# DEMANDE DE BREVET EUROPEEN

(11) **EP 2 632 000 A1**
(43) Date de publication de la demande: **28.08.2013**
(21) Numéro de dépôt: 13154886.9
(22) Date de dépôt: 12.02.2013
(51) Int. Cl.: H02B 1/01, H02B 1/30

(54) **Ossature d'un coffret ou d'une armoire électrique**

(30) Priorité: 21.02.2012 FR 1251565
(71) Demandeur: Schneider Electric Industries SAS, 92500 Rueil-Malmaison (FR)
(72) Inventeur: Masse, Dominique, 91360 Epinay sur Orge (FR); Dognon, Mikaël, 95220 Herblay (FR)
(74) Mandataire: Bié, Nicolas

(57) **Abrégé**

L'invention concerne une ossature (1) parallélépipédique d'un coffret ou d'une armoire électrique, comportant :
- une première base (b1) et une deuxième base (b2) rectangulaires, formées chacune par quatre montants (10, 11),
- quatre montants latéraux (12, 13, 14, 15) perpendiculaires aux bases et reliant les deux bases entre elles, formant quatre faces latérales (f1, f2, f3, f4) parallèles deux à deux, deux premières faces latérales (f1, f3) parallèles comportant chacune un montant oblique (16, 17) fixé suivant une diagonale de ladite face,
- les quatre montants latéraux (12, 13, 14, 15) et les deux montants obliques (16, 17) comportant des extrémités de fixation articulées sur chacune des deux bases (b1, b2), agencées pour faire pivoter lesdits montants obliques (16, 17) et latéraux (12, 13, 14, 15) suivant deux plans formés par lesdites premières faces latérales (f1, f3) de manière à manoeuvrer l'ossature entre une position pliée et une position dépliée.

## Description

### Domaine technique de l'invention

La présente invention se rapporte à une ossature d'un coffret ou d'une armoire électrique. L'ossature de l'invention présente la particularité d'être pliable.

### Etat de la technique

Un coffret ou une armoire électrique comporte une ossature dotée de plusieurs montants sur lesquels viennent se fixer des panneaux. Le montage de l'ossature est réalisé en fixant les montants entre eux à l'aide de vis. Ce montage s'avère être particulièrement long.

L'objectif de l'invention est de proposer une ossature pour coffret ou armoire électrique dont le stockage, le transport, la manutention, le montage et l'installation sont aisés.

### Exposé de l'invention

Ce but est atteint par une ossature parallélépipédique d'un coffret ou d'une armoire électrique, comportant :
- une première base et une deuxième base rectangulaires, formées chacune par quatre montants,
- quatre montants latéraux perpendiculaires aux bases et reliant les deux bases entre elles, formant quatre faces latérales parallèles deux à deux,
- deux premières faces latérales parallèles comportant chacune un montant oblique fixé suivant une diagonale de ladite face,
- les deux montants obliques sont télescopiques,
- les quatre montants latéraux et les deux montants obliques comportent des extrémités de fixation articulées sur chacune des deux bases agencées pour faire pivoter lesdits montants obliques et latéraux suivant deux plans formés par lesdites premières faces latérales de manière à pouvoir manoeuvrer l'ossature entre une position pliée et une position dépliée.

Selon une particularité, les quatre montants latéraux sont télescopiques et les deux montants obliques et les quatre montants latéraux comportent des moyens de verrouillage de la position de la première base par rapport à la deuxième base lorsque l'ossature est en position dépliée.

Selon une autre particularité, les moyens de verrouillage comportent plusieurs orifices réalisés sur les montants et des organes de verrouillage coopérant avec lesdits orifices.

Selon une autre particularité, les orifices sont réalisés sur la longueur de chaque montant de manière à régler la taille de l'ossature.

### Brève description des figures

D'autres caractéristiques et avantages vont apparaître dans la description détaillée qui suit faite en regard des dessins annexés dans lesquels :
- la figure 1 représente l'ossature de l'invention, en position pliée,
- la figure 2A représente l'ossature de l'invention, en position dépliée,
- la figure 2B représente le détail A présent sur la figure 2A,
- la figure 2C représente le détail B présent sur la figure 2A,
- la figure 3 représente l'ossature de l'invention, en position dépliée et agrandie.

### Description détaillée d'au moins un mode de réalisation

L'invention concerne une ossature 1 métallique pour coffret ou armoire électrique. Cette ossature 1 présente la particularité d'être pliable, ce qui lui permet d'être facilement stockée, transportée et montée rapidement par une seule personne.

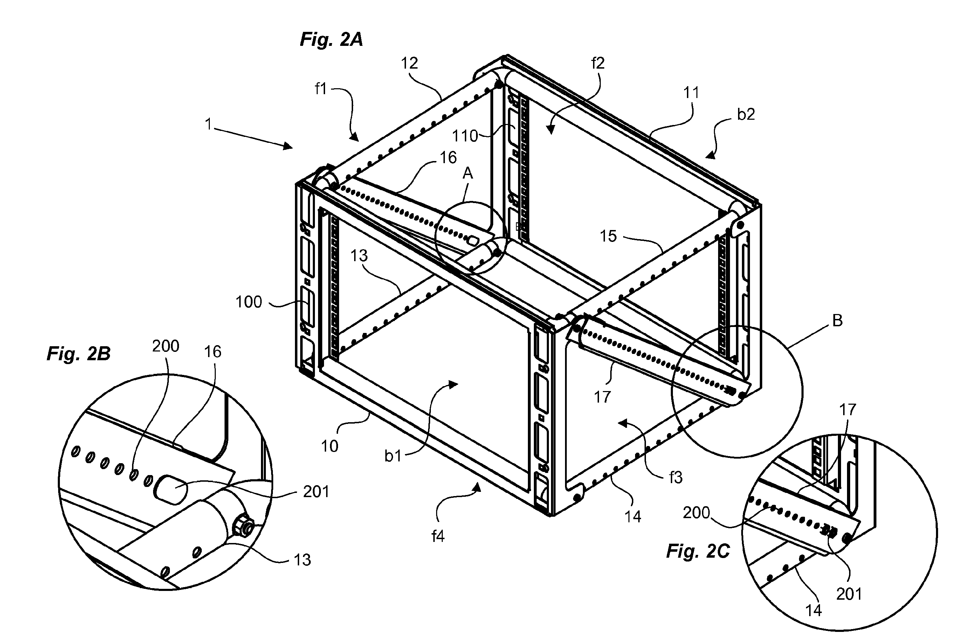

En position dépliée, l'ossature 1 a une forme de parallélépipède rectangle (figure 2A). Elle comprend deux bases identiques, une première base b1 et une deuxième base b2, formées chacune de quatre montants 10, 11 assemblés en rectangle. Les montants des bases 10, 11 comportent par exemple des ouvertures 100, 110 permettant la fixation d'accessoires ou le passage de câbles ou cordons entre l'avant et l'arrière de l'ossature.

Les deux bases b1, b2 sont montées parallèles et sont assemblées entre elles grâce à quatre montants latéraux 12, 13, 14, 15. Les quatre montants latéraux sont perpendiculaires aux deux bases b1, b2 de manière à former quatre faces f1, f2, f3, f4 latérales parallèles deux à deux, désignées premières faces latérales f1, f3 et deuxièmes faces latérales f2, f4. Les quatre montants 10, 11 de chaque base b1, b2 et les montants latéraux forment ainsi les arêtes de l'ossature 1 de l'invention. Les deux premières faces latérales f1, f3 comportent chacune un montant oblique 16, 17 s'étendant suivant la diagonale de la face. Les deux montants obliques 16, 17 sont parallèles et sont orientés suivant un même plan oblique.

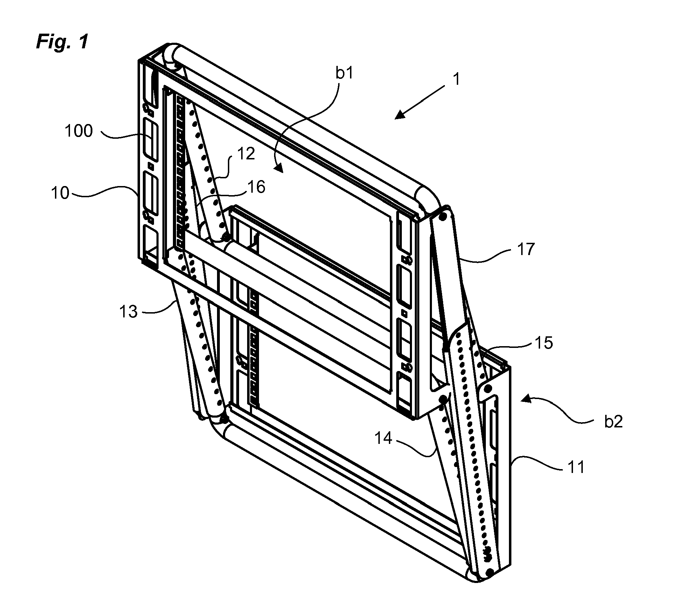

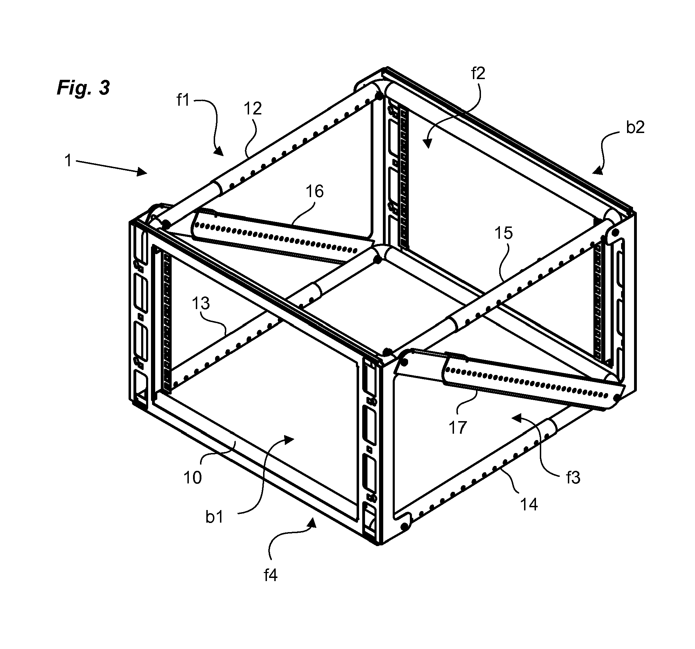

Les quatre montants latéraux 12, 13, 14, 15 et les deux montants obliques 16, 17 comportent chacun deux extrémités de fixation articulées sur chacune des deux bases b1, b2 de manière à pouvoir pivoter dans les deux plans formés par lesdites premières faces latérales f1, f3. L'ossature 1 peut ainsi se plier et se déplier en faisant pivoter les montants latéraux 12, 13, 14, 15 et obliques 16, 17 autour de leurs extrémités dans les deux plans. Les montants obliques 16, 17 présentent pour cela une structure télescopique autorisant le pliage et le dépliage. L'ossature 1 de l'invention peut ainsi prendre une position pliée (figure 1) dans laquelle les deux bases sont ramenées l'une vers l'autre et une position dépliée dans laquelle l'ossature forme un parallélépipède rectangle (figures 2A et 3).

Selon l'invention, les quatre montants latéraux 12, 13, 14, 15 présentent préférentiellement une forme tubulaire, à section circulaire. Ils comportent une structure télescopique permettant d'être ajustés en longueur. Comme les deux montants obliques présentent également une structure télescopique permettant de s'ajuster en longueur, il est ainsi possible de régler la distance séparant les deux bases en position dépliée et ainsi de régler la taille du coffret ou de l'armoire électrique formée à partir de ladite ossature. La figure 3 présente ainsi l'ossature 1 de l'invention en position dépliée et agrandie.

Les quatre montants latéraux 12, 13, 14, 15 et les deux montants obliques 16, 17 comportent des orifices 200 (figures 2B et 2C) dans lesquels viennent s'insérer des organes de verrouillage 201 permettant de verrouiller la position dépliée de l'ossature 1 et la taille de ladite ossature 1 en position dépliée. Ces organes de verrouillage 201 comportent par exemple une ou plusieurs vis venant se loger dans les orifices 200 des montants pour verrouiller leur position en longueur. Pour verrouiller l'ossature 1 en position et en taille, d'autres moyens équivalents peuvent bien entendu être employés.

L'ossature 1 de l'invention présente ainsi plusieurs avantages. Elle peut être logée facilement dans un emballage puis, une fois amenée sur site, montée rapidement sans nécessiter une main d'oeuvre conséquente.

## Revendications

1. Ossature (1) parallélépipédique d'un coffret ou d'une armoire électrique, comportant :
- une première base (b1) et une deuxième base (b2) rectangulaires, formées chacune par quatre montants (10, 11),
- quatre montants latéraux (12, 13, 14, 15) perpendiculaires aux bases et reliant les deux bases entre elles, formant quatre faces latérales (f1, f2, f3, f4) parallèles deux à deux,
**caractérisée en ce que :**
- deux premières faces latérales (f1, f3) parallèles comportent chacune un montant oblique (16, 17) fixé suivant une diagonale de ladite face,
- les deux montants obliques (16, 17) sont télescopiques,
- les quatre montants latéraux (12, 13, 14, 15) et les deux montants obliques (16, 17) comportent des extrémités de fixation articulées sur chacune des deux bases (b1, b2) agencées pour faire pivoter lesdits montants obliques (16, 17) et latéraux (12, 13, 14, 15) suivant deux plans formés par lesdites premières faces latérales (f1, f3) de manière à pouvoir manoeuvrer l'ossature entre une position pliée et une position dépliée.

2. Ossature selon la revendication 1, **caractérisée en ce que** les quatre montants latéraux (12, 13, 14, 15) sont télescopiques et **en ce que** les deux montants obliques (16, 17) et les quatre montants latéraux comportent des moyens de verrouillage de la position de la première base (b1) par rapport à la deuxième base (b2) lorsque l'ossature est en position dépliée.

3. Ossature selon la revendication 2, **caractérisée en ce que** les moyens de verrouillage comportent plusieurs orifices (200) réalisés sur les montants et des organes de verrouillage (201) coopérant avec lesdits orifices (200).

4. Ossature selon la revendication 3, **caractérisée en ce que** les orifices sont réalisés sur la longueur de chaque montant de manière à régler la taille de l'ossature (1).
